# FASCICULE DE BREVET EUROPEEN

(11) **EP 3 994 962 B1**
(45) Date de publication et mention de la délivrance du brevet: **22.05.2024**
(21) Numéro de dépôt: 20742331.0
(22) Date de dépôt: 12.06.2020
(51) Int. Cl.: H05K 1/11, H05K 3/40, H05K 3/28, H05K 3/36, G06K 19/077, H05K 1/03, H05K 1/14, H05K 3/00, G06K 19/02

(54) **DISPOSITIF DE CONNEXION DE CARTE À PUCE SUR TEXTILE ET PROCÉDÉ DE FABRICATION DE FABRICATION DE CARTES ÉLECTRONIQUES DANS UN FORMAT CARTE À PUCE SOUPLE**
CHIP-ANSCHLUSSKARTE AUF FASERSTOFF UND HERSTELLUNGSVERFAHREN VON ELEKTRONISCHEN KARTEN IN EINEM FLEXIBLEN CHIPKARTE FORMAT
CHIP CONNECTION CARD ON A FABRIC AND MANUFACTURING METHOD OF ELECTRONIC CARDS IN A SOFT CHIP CARD FORMAT

(30) Priorité: 05.07.2019 FR 1907533
(43) Date de publication de la demande: 11.05.2022
(73) Titulaire: Linxens Holding, 78200 Mantes-la-Jolie (FR)
(72) Inventeur: VASSAL, Simon, 92110 CLICHY (FR); MATHIEU, Christophe, 78200 MANTES-LA-JOLIE (FR)
(74) Mandataire: Plasseraud IP
(86) Numéro de dépôt international: PCT/FR2020/051008
(87) Numéro de publication internationale: WO 2021/005278

(56) Documents cités:
- EP-A1- 2 937 823
- EP-A2- 1 489 696
- WO-A1-2014/096140
- WO-A1-2016/122317
- WO-A2-03/028044
- DE-A1-102011 005 606
- KR-A- 20080 114 107
- US-A1- 2018 338 544

## Description

### Domaine technique

La présente invention concerne la connexion entre une carte de type carte à puce et des pistes conductrices d'un vêtement « intelligent ».

On appelle vêtement intelligent un vêtement muni de dispositifs électroniques tels que des capteurs biologiques ou physiologiques, des moyens de chauffage ou autres dispositifs électroniques intégrés dans le vêtement.

Dans le cas de capteurs biologiques ou physiologiques enregistrant des paramètres corporels il peut être nécessaire de disposer d'un dispositif électronique de mesure amovible qui se connecte à des liaisons électriques issues des capteurs du vêtement pour réaliser une surveillance ou un enregistrement et puisse être retiré du vêtement, par exemple pour récolter des données de mesure, et remis simplement en position, par exemple pour reprendre une surveillance.

### Technique antérieure

Il est connu pour réaliser des enregistrements de données biométriques de relier des capteurs corporels à des boîtiers de mesure munis de circuits imprimés porteurs de composants électroniques. Toutefois de tels dispositifs sont inconfortables à porter du fait que les vêtements sont souples et extensibles alors que les boîtier et circuits imprimés sont rigides. En outre ils doivent être connectés aux capteurs au travers de câbles de liaison et de connecteurs rigides.

Il est aussi connu d'utiliser des boutons pressions pour raccorder des capteurs physiologiques d'un vêtement à un dispositif de mesure ou de mémorisation.

Le document WO 2016/122317 A1 concerne un module et une méthode pour la connexion sur une étoffe comportant des pistes conductrices.

WO 03/028044 A2 concerne un substrat isolant formant une bande ou un panneau et pourvu de supports de puces destinées à être disposés dans des cartes à puces.

EP 2 937 823 A1 concerne un procédé de fabrication d'une de carte à puce. Selon ce procédé, on réalise tout d'abord une structure avec un substrat supportant des contacts, d'une part, et une antenne d'autre part. Une puce électronique est également connectée électriquement à au moins certains des contacts et à l'antenne, puis encapsulée.

### Résumé

Au vu de cet art antérieur, une amélioration de la connexion de capteurs d'un vêtement intelligent à un dispositif électronique de mesure ainsi qu'une miniaturisation d'un tel dispositif de mesure sont recherchées. L'invention est divulguée dans les revendications annexées.

### Brève description des dessins

D'autres caractéristiques, détails et avantages apparaîtront à la lecture de la description détaillée ci-après, et à l'analyse des dessins annexés, sur lesquels :
[Fig. 1] montre un exemple de carte électronique de la présente demande ;
[Fig. 2] représente une vue de dessus en transparence d'un exemple d'ébauche de circuit souple en rapport avec la présente demande;
[Fig. 3] représente une vue de dessus en transparence du circuit souple issu de l'ébauche de la figure 2
[Fig. 4A], [Fig. 4B], [Fig. 4C] représentent des variantes de réalisation selon la présente demande ;
[Fig. 5] représente une vue schématique d'une carte de la demande implantée dans un vêtement ;
[Fig. 6] représente un détail en coupe d'une carte de la demande comportant un circuit souple ;
[Fig. 7] représente un détail en coupe d'une carte de la demande comportant deux circuits souples.

### Description des modes de réalisation

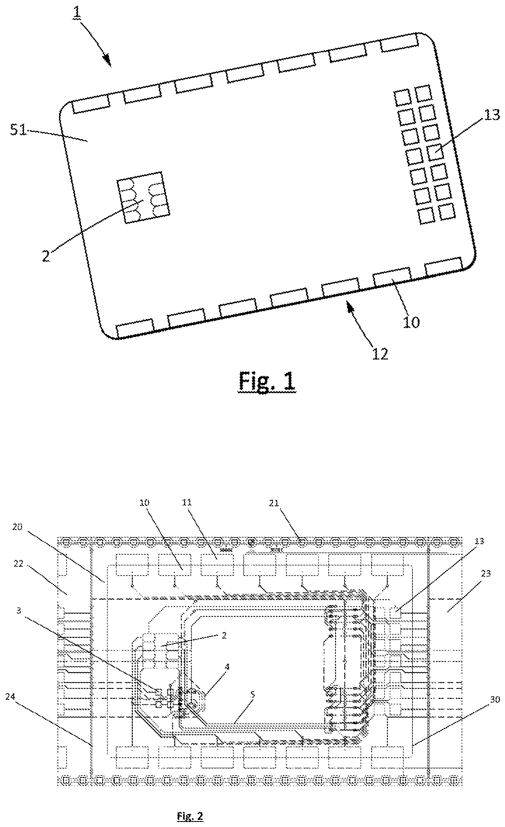

La présente demande concerne une carte électronique sous forme d'une carte souple 1 dans un format de type carte à puce ou carte de crédit telle que représentée en figure 1. La carte électronique comporte des languettes de contact 10, destinées à être reliées à des pistes conductrices d'un textile de vêtement, alignées sur deux bords opposés de la carte et une face supérieure 51 de réalisation d'une face externe de la carte munie de découpes laissant les languettes apparentes sur le dessus de la carte. Elle comporte en outre, selon l'exemple représenté et de manière non obligatoire des pastilles de contact 2 avec un lecteur de carte à puce standard et de manière optionnelle des pastilles 13 de connexion avec un outil de test ou de programmation.

Dans d'autres modes de réalisation, les pastilles de contact peuvent être remplacées ou complétées par une antenne telle qu'une antenne RFID ou une antenne radio telle qu'une antenne Bluetooth ou Wifi réalisée sur le circuit souple.

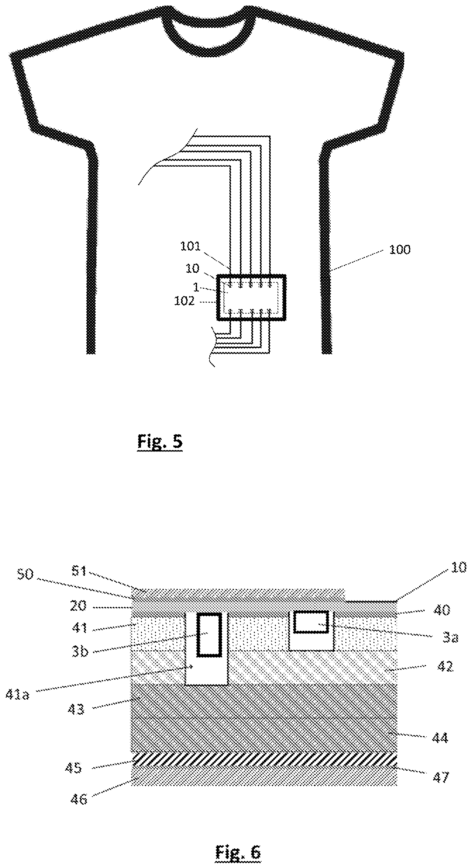

Un exemple d'application de la carte est schématisé en figure 5 pour laquelle des pistes conductrices 101 d'un vêtement intelligent 100 ont des terminaisons, par exemple dans une poche 102 ou un logement du vêtement recevant la carte 1 et pour lequel ces pistes conductrices sont mises en contact avec les languettes de contact 10.

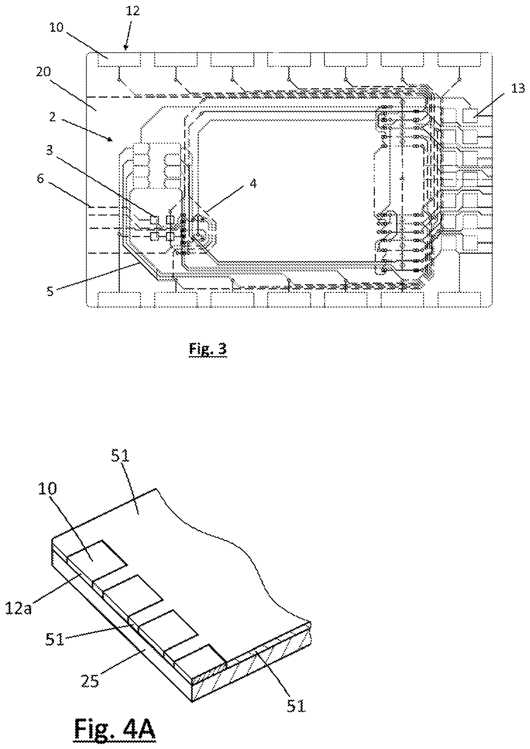

La carte électronique est pourvue d'un circuit souple 20 représenté selon plusieurs étapes de découpe aux figures 2 et 3. Ce circuit souple comporte une face inférieure recevant des composants électroniques 3a, 3b sur des pastilles de connexion 3 reliées à des pistes conductrices 4 et une face supérieure pourvue des languettes de contact 10. Il comporte, de manière traditionnelle, des pistes de connexion 5 qui relient les différents composants et points de connexion du circuit souple avec les pistes 4. Le substrat du circuit souple peut être réalisé avec un matériau tel que le polyimide (PI), un composite verre époxy, le polytéréphtalate d'éthylène PET, le Polyéthylène naphtalate PEN, un papier industriel ou autre matériau adapté.

Par convention on parlera ici de face supérieure pour la face de la carte comportant les languettes et pastilles de contact et de face inférieure pour la face de la carte dépourvue de moyens de contact dans le cas d'une carte avec contacts sur une seule face.

Selon la figure 6, le circuit souple est recouvert sur sa face inférieure d'une part d'au moins une couche inférieure 40 d'adhésif de liaison, notamment un adhésif polyuréthane et de premières couches polymères 41, 42, par exemple une ou plusieurs couches pourvues de découpes 41a de réception des composants 3a, 3b et, d'autre part de secondes couches polymères 43, 44 de protection, l'ensemble de ces couches réalisant une encapsulation des composants 3a, 3b.

Les couches de protection peuvent être une ou plusieurs couches PVC supplémentaires 43, 44 qui permettent en outre d'accroître l'épaisseur de la carte si nécessaire. Sous les couches d'encapsulation se trouve une couche de couverture 45 et une couche PET de formation d'une face externe de la carte 46. Cette couche forme une couche d'aspect qui est selon l'exemple collée sous la couche de protection avec une couche d'adhésif 47 tel qu'un adhésif polyuréthane.

Toujours selon la figure 6, le circuit souple est recouvert sur sa face supérieure d'une couche supérieure 50 d'adhésif polyuréthane de liaison et d'au moins une couche supérieure 51 de réalisation d'une face externe de la carte en matériau polymère tel qu'un PET. La couche d'adhésif et la couche supérieure sont pourvues de découpes d'accès aux languettes de contact 10.

Il est à noter que l'épaisseur des languettes de contact peut être inférieure à la somme des épaisseurs de la couche d'adhésif et de la couche supérieure de matériau polymère du fait que le procédé de fabrication comporte une étape de laminage de la carte qui va lier les couches ensemble et, dans le cas présent repousser le circuit souple dans les ouvertures de la couche supérieure de sorte que les languettes affleurent la surface supérieure de la carte.

Selon la présente demande comme représenté par exemple aux figures 4A à 4C, une pluralité de languettes de contact est réalisée en bord de carte et ces languettes sont pourvues d'une partie terminale 12a, 12b, 12c sur la tranche 25 de la carte.

Selon la figure 4A, les parties terminales des languettes de contact 12a sur la tranche de la carte sont de niveau avec le plan de la tranche 25 de la carte.

Dans ce cas, les languettes peuvent avoir un bord arrondi ou une arête vive selon que la carte est découpée respectivement par le dessous ou par le dessus.

Il a toutefois été déterminé qu'une découpe réalisant un bord arrondi était plus favorable pour une connexion fiable avec les pistes du vêtement.

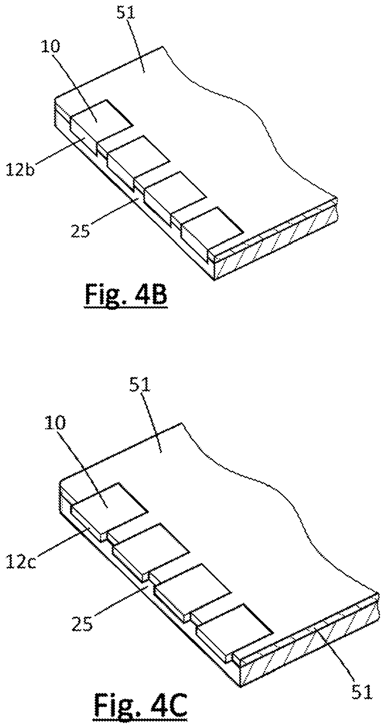

Selon la figure 4B, les parties terminales des languettes de contact sur la tranche de la carte sont des parties de languettes 12b recourbées sur la tranche 25 de la carte.

Selon la figure 4C, les parties terminales des languettes de contact sont des parties en porte à faux 12c sur la tranche 25 de la carte. Dans ce cas les languettes de contact conservent des parties débordant du contour de la carte lors de la découpe du contour de la carte par exemple en utilisant un dispositif poinçon/matrice étagé.

Le procédé de fabrication de la carte comporte en premier lieu la réalisation d'ébauches de circuits souples à partir d'une bande représentée en figure 2 sur laquelle une pluralité de circuits souples 20, 22, 23 sont tracés. Ces ébauches sont pourvues de perforations latérales de manutention 21 sur deux bords opposés, de pistes de connexion 4, 5 en surface supérieure et en surface inférieure et sont pourvues de languettes de contact 10 alignées le long d'au moins un desdits bords opposés et à proximité dudit bord.

Les composants électroniques sont positionnés sur des pastilles de connexion 3 sur la face inférieure des circuits souples. Ces composants sont reliés aux pistes de connexion 4 de la face inférieure par toute technique connue telle que soudure, brasure, puces retournées, CMS ou pontage.

Une fois les circuits souples en bande munis de leurs composants, les ébauches de circuits souples sont séparées en coupant les circuits au niveau des lignes 24.

Dans une étape ultérieure il est réalisé un empilage de couches pour réaliser la ou les cartes. Plusieurs ébauches de circuits souples sont préférablement disposées ensemble sur un même ensemble de feuilles polymères rectangulaire avec par exemple des circuits disposés en lignes et en colonnes sur les feuilles. Par exemple des planches de 24 circuits en 6 lignes et 4 colonnes voir plus sont réalisées.

La réalisation peut commencer par la réalisation d'un empilage de feuilles polymères partant par exemple d'une face inférieure de la carte et débutant par une couche externe polymère 46, puis éventuellement une couche d'adhésif 47 et une couche de de protection 45 puis un ensemble de couches polymères d'encapsulation des composants, comprenant ici des couches polymères 41, 42, pourvues de découpes de passage des composants, et des couches 43, 44 de fermeture et le dépôt sur cet ensemble de la première face de l'ébauche ou des ébauches de circuits souples. Une couche d'adhésif 40 peut dans certains cas être intercalée entre les ébauches de circuits souples et les couches polymères.

Dans ce cas, sur la face supérieure des circuits souples, est déposées une feuille d'une couche polymère 51 de réalisation d'une face externe de la carte pourvue de découpes laissant apparentes les languettes de contact 10. Une couche d'adhésif 50 peut aussi être prévue entre la face supérieure du circuit souple et la feuille formant la couche polymère.

L'ensemble des couches est représenté dans cet ordre en coupe de côté en figure 6 mais le procédé peut commencer par la couche supérieure externe 51 et les dépôts successifs étant réalisés dans l'ordre inverse.

L'ensemble est alors laminé avec un pressage et un chauffage pour lier les couches. Le laminage peut notamment se faire en plusieurs étapes avec une pression allant d'une dizaine de N/cm2 à une centaine de N/cm2 avec une température allant jusqu'à 160°C puis une pression allant jusqu'à environ 250 N/cm2 à une température de l'ordre de la température ambiante.

Il est à noter que, en fonction du type de laminage ou de matériaux plastiques utilisés, la pose de couches d'adhésif peut être évitée ou nécessaire.

Comme vu plus haut un aspect intéressant est que lors du laminage, le circuit souple est repoussé par les couches inférieures dans les découpes réalisées dans les couches supérieures et la surface des languettes et éventuellement des pastilles vient affleurer la surface supérieure de la carte du fait que les parties de circuit souple au niveau des découpes de l'adhésif et de la couche supérieure de matériau polymère sont repoussées dans ces découpes. Il n'est ainsi pas besoin de réaliser les pastilles et les languettes avec une épaisseur équivalente à l'épaisseur de la couche supérieure. Par contre il est préférable que les composants sous le circuit souples soient disposés à distance de ces découpes pour éviter des problèmes de connexion lors du repoussage du circuit souple.

Ensuite on réalise une découpe du tour des cartes selon le tracé de découpe définitif de la carte avec un dispositif de type poinçon/matrice.

Selon la présente demande, la position des languettes par rapport audit bord est fixée de sorte que ladite découpe laisse l'extrémité des languettes à nu sur la tranche de la carte.

Plusieurs modes de réalisation de la zone de connexion en bord de carte sont possibles.

La découpe peut cisailler une partie de chute 11 des languettes 10 selon le tracé de découpe 30 de la figure 2 ce qui permet d'avoir une tolérance de fabrication plus grande en obtenant ainsi une zone de connexion en bord de carte ;

La découpe du bord de carte peut aussi affleurer l'extrémité des languettes ce qui minimise les pertes de métal constituant les languettes tout en conservant une zone de connexion en bord de carte.

Dans les deux cas, les bords des languettes sur la carte restent dans le plan de la tranche de la carte ou dépassent légèrement du bord de carte.

Pour la découpe on préférera positionner l'assemblage de sorte que la face supérieure portant les languettes de contact repose contre la matrice et appliquer le poinçon côté face inférieure côté composants et couches d'encapsulation ce qui donne des parties terminales ou bords arrondis aux extrémités des languettes en bord de carte.

Dans le cas où le poinçon est appliqué côté supérieur, les arêtes des languettes sont des arêtes vives.

Les cartes électroniques réalisées selon la présente demande assurent une connexion efficace avec les conducteurs ou pistes conductrices 101 du vêtement et peuvent être insérées et retirées aisément des poches ou logements 102 les recevant, le contact des languettes 10 avec les pistes 101 du vêtement s'établissant ou se rétablissant lors de l'insertion ou la réinsertion des cartes dans les poches.

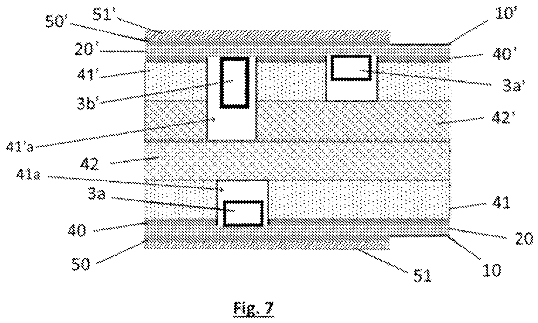

Un mode de réalisation alternatif prévoit des cartes comportant des languettes sur leurs deux faces. Dans ce cas l'empilage correspond à l'exemple de la figure 7 et est symétrique par rapport à un plan médian pour comporter depuis le bas vers le haut de la figure une couche externe 51 et une couche d'adhésif 50 pourvue de découpe d'accès aux languettes 10, le premier circuit souple 20 avec ses languettes 10 tournées vers le bas une deuxième couche d'adhésif 40, les couches 41, 42 pourvues de découpe de passage des composants 3a du premier circuit souple éventuellement une ou plusieurs couches refermant les passages de composants non représentées, les couches 42', 41' pourvues de découpes de passage des composants 3'a, 3'b du second circuit souple, une troisième couche d'adhésif 40' sur laquelle est positionné le second circuit souple 20' une quatrième couche de colle 50' et la seconde couche externe 51', ces deux dernières couches étant pourvues de découpes pour laisser passer les languettes 10'.

Dans ce mode de réalisation, le laminage va permettre de coller l'ensemble des couches et de réaliser le repoussage des languettes de contact dans les découpes des deux faces.

L'invention n'est pas limitée aux exemples représentés et notamment le nombre de languettes peut être modifié et le nombre de couches telles que les couches de protection 43, 44 complétant l'encapsulation des composants peut être adapté en fonction de l'épaisseur désirée pour la carte.

## Revendications

1. Carte électronique réalisée dans un format tel qu'un format carte de crédit et notamment dans un format carte à puce souple (1), est pourvue d'au moins un circuit souple (20) comportant une première face recevant des composants électroniques (3) et une seconde face pourvue de languettes de contact (10) destinées à être reliées à des pistes conductrices d'un textile de vêtement, ledit circuit souple étant recouvert sur sa première face de premières couches polymères d'encapsulation des composants (41, 42, 43, 44) et recouvert sur sa seconde face d'au moins une première couche (51) de matériau polymère de réalisation d'une face externe de la carte pourvue de découpes d'accès aux languettes de contact (10) **caractérisé en ce que** au moins certaines des languettes de contact sont réalisées en bord de carte et pourvues d'une partie terminale (12) sur la tranche de la carte.

2. Carte électronique selon la revendication 1, pour laquelle la seconde face du circuit souple comporte, à distance des bords de la carte, des pastilles de contact (2) de connexion avec un lecteur de carte à puce.

3. Carte électronique selon la revendication 1 ou 2, pour laquelle la carte étant une carte laminée, lesdites languettes de contact (10) affleurent à la surface de la carte après laminage.

4. Carte électronique selon la revendication 1, 2 ou 3, pour laquelle les parties terminales des languettes de contact (12a) sur la tranche (25) de la carte sont de niveau avec le plan de la tranche de la carte et comportent une arête vive ou arrondie.

5. Carte électronique selon la revendication 1, 2 ou 3, pour laquelle les parties terminales des languettes de contact sur la tranche de la carte sont des parties des languettes arrondies ou recourbées (12b) ou des parties en porte à faux (12c) sur la tranche (25) de la carte.

6. Carte électronique selon l'une quelconque des revendications précédentes pour lequel les premières couches polymères d'encapsulation des composants sont recouvertes par au moins une couche de matériau polymère de protection et une seconde couche de matériau polymère (51) de réalisation d'une face externe de la carte.

7. Carte électronique selon l'une quelconque des revendications 1 à 5 comportant deux circuits souples (20, 20') pourvus de languettes de contact réalisées en bord de carte, chacun disposé sous une face externe de la carte, lesdits circuits souples étant séparés par des couches polymères d'encapsulation des composants (41, 42, 41', 42').

8. Carte électronique selon l'une quelconque des revendications précédentes pour laquelle une ou plusieurs couches d'adhésif sont interposées entre le circuit souple et les couches polymères.

9. Procédé de fabrication de cartes électroniques dans un format carte à puce souple comportant :
a. la réalisation d'au moins une ébauche de circuit souple (20) pourvue de perforations latérales de manutention (21) sur deux bords opposés, de pistes de connexion (4, 5) sur une première face et sur une seconde face de ladite ébauche, pourvue en outre sur sa seconde face de languettes de contact (10) alignées le long d'au moins un desdits bords et à proximité dudit bord;
b. le dépôt de composants électroniques (3a, 3b) reliés à au moins une partie des pistes de connexion (4) d'une première face de ladite ébauche de circuit souple par soudure, brasure, puces retournées, CMS ou pontage sur ladite première face de ladite ébauche de circuit souple;
**caractérisé en ce qu'**il comporte en outre :
c. La réalisation d'un empilage de couches autour de l'ébauche de circuit souple tel que l'empilage comporte au moins des premières couches polymères d'encapsulation des composants (41, 42) côté première face de l'ébauche de circuit souple et comporte au moins une deuxième couche polymère (51) de réalisation d'une face externe de la carte du côté seconde face de l'ébauche de circuit souple (20), ladite au moins une deuxième couche polymère étant pourvue de découpes d'accès auxdites languettes de contact (10) alignées le long d'au moins un desdits bords et à proximité dudit bord;
d. un laminage à chaud ou à froid de l'ensemble des feuilles et de ladite au moins une ébauche de circuit souple,
e. une découpe de tour de carte sur l'ensemble des couches laminées telle que la position de la découpe de tour de carte par rapport audit bord est fixée de sorte que ladite découpe de tour de carte laisse une partie desdites languettes de contact (10) à nu sur la tranche de la carte.

10. Procédé selon la revendication 9, pour lequel l'empilage comporte en outre, avant le laminage, une couche polymère de protection (45) une deuxième couche de matériau polymère (46) de formation d'une seconde face de la carte sur les premières couches polymères (41, 42) d'encapsulation des composants.

11. Procédé selon la revendication 9 pour lequel la carte comportant deux circuits souples, le procédé comporte en outre, avant le laminage :
a. le dépôt, sur les premières couches (41, 42) d'encapsulation des composants, de secondes couches (42', 41') d'encapsulation de composants d'un second circuit souple;
b. le dépôt de la première face du second circuit souple (20') sur lesdites secondes couches;
c. le dépôt, sur la seconde face du second circuit souple, d'une seconde couche de matériau polymère (51') de formation d'une seconde face de la carte.

12. Procédé selon l'une quelconque des revendications 9, 10 ou 11, pour lequel la découpe de tour de carte affleure l'extrémité des languettes.

13. Procédé selon l'une quelconque des revendications 9, 10 ou 11, pour lequel la découpe de tour de carte cisaille une partie de chute des languettes.

14. Procédé selon l'une quelconque des revendications 9 à 13, pour lequel la découpe de tour de carte est faite au moyen d'un dispositif poinçon/matrice.

15. Procédé selon l'une quelconque des revendications 9 à 14 comportant une ou plusieurs étapes de pose d'adhésif entre une ou plusieurs faces du circuit souple et une ou plusieurs couches polymères.

## Patentansprüche

1. Elektronische Karte, welche in einem Format, wie beispielsweise einem Kreditkarten-Format und insbesondere in einem Format einer Karte mit flexiblem Chip (1), gebildet und mit wenigstens einer flexiblen Schaltung (20) versehen ist, welche eine erste Fläche, welche elektronische Komponenten (3) aufnimmt, und eine zweite Fläche umfasst, welche mit Kontaktstreifen (10) versehen ist, welche dazu vorgesehen sind, mit leitfähigen Bahnen eines Kleidungstextils verbunden zu werden, wobei die flexible Schaltung an ihrer ersten Fläche mit ersten Polymerschichten zur Verkapselung von Komponenten (41, 42, 43, 44) bedeckt ist und an ihrer zweiten Fläche mit wenigstens einer ersten Schicht (51) aus Polymermaterial zum Bilden einer externen Fläche der Karte bedeckt ist, welche mit Zugangsausschnitten zu den Kontaktstreifen (10) versehen ist, **dadurch gekennzeichnet, dass** wenigstens bestimmte der Kontaktstreifen an einem Rand der Karte gebildet sind und mit einem Endabschnitt (12) an der Randfläche der Karte versehen sind.

2. Elektronische Karte nach Anspruch 1, wobei die zweite Fläche der flexiblen Schaltung bei einem Abstand zu den Rändern der Karte Kontaktfelder (2) zur Verbindung mit einem Lesegerät der Chipkarte umfasst.

3. Elektronische Karte nach Anspruch 1 oder 2, wobei die Karte eine laminierte Karte ist, wobei die Kontaktstreifen (10) mit der Fläche der Karte nach der Laminierung plan sind.

4. Elektronische Karte nach Anspruch 1, 2 oder 3, wobei die Endabschnitte der Kontaktstreifen (12a) an der Randfläche (25) der Karte mit der Ebene der Randfläche der Karte ausgerichtet sind und eine scharfe oder abgerundete Kante umfassen.

5. Elektronische Karte nach Anspruch 1, 2 oder 3, wobei die Endabschnitte der Kontaktstreifen an der Randfläche der Karte abgerundete oder gekrümmte Streifenabschnitte (12b) oder auskragende Abschnitte (12c) an der Randfläche (25) der Karte sind.

6. Elektronische Karte nach einem der vorhergehenden Ansprüche, wobei die ersten Polymerschichten zur Verkapselung von Komponenten von wenigstens einer Schutzschicht aus Polymermaterial und einer zweiten Schicht aus Polymermaterial (51) zum Bilden einer externen Fläche der Karte bedeckt sind.

7. Elektronische Karte nach einem der Ansprüche 1 bis 5, umfassend zwei flexible Schaltungen (20, 20`), welche mit Kontaktstreifen versehen sind, welche an einem Rand der Karte gebildet sind, welche jeweils unter einer externen Fläche der Karte angeordnet sind, wobei die flexiblen Schaltungen durch die Polymerschichten zur Verkapselung von Komponenten (41, 42, 41', 42') getrennt sind.

8. Elektronische Karte nach einem der vorhergehenden Ansprüche, wobei eine oder mehrere Haftschichten zwischen der flexiblen Schaltung und den Polymerschichten eingefügt sind.

9. Verfahren zur Herstellung von elektronischen Karten in einem Format mit flexiblem Chip, umfassend:
a. das Bilden von wenigstens einem Rohling einer flexiblen Schaltung (20), welcher mit lateralen Handhabungsperforationen (21) an zwei gegenüberliegenden Rändern versehen ist, mit Verbindungsbahnen (4, 5) an einer ersten Fläche und an einer zweiten Fläche des Rohlings, ferner versehen an seiner zweiten Fläche mit Kontaktstreifen (10), welche entlang wenigstens einem der Ränder und in der Nähe des Rands ausgerichtet sind;
b. Anbringen von elektrischen Komponenten (3a, 3b), welche mit wenigstens einem Teil der Verbindungsbahnen (4) einer ersten Fläche des Rohlings der flexiblen Schaltung durch Schweißen, Löten, Flip-Chip, SMD oder Bonding an der ersten Fläche des Rohlings der flexiblen Schaltung verbunden sind;
**dadurch gekennzeichnet, dass** es ferner umfasst:
c. das Bilden eines Stapels von Schichten um den Rohling der flexiblen Schaltung herum derart, dass der Stapel wenigstens erste Polymerschichten zur Verkapselung von Komponenten (41, 42) an der Seite der ersten Fläche des Rohlings der flexiblen Schaltung umfasst und wenigstens eine zweite Polymerschicht (51) zum Bilden einer externen Fläche der Karte an der Seite der zweiten Fläche des Rohlings der flexiblen Schaltung (20) umfasst, wobei die wenigstens eine zweite Polymerschicht mit Zugangsausschnitten zu den Kontaktstreifen (10) versehen ist, welche entlang wenigstens einem der Ränder und in der Nähe des Rands ausgerichtet sind;
d. ein Kalt- oder Heißlaminieren der Anordnung von Blättern und des wenigstens einen Rohlings einer flexiblen Schaltung,
e. ein Ausschneiden der Karte aus der Anordnung von laminierten Schichten derart, dass die Position des Ausschneidens der Karte um den Rand derart festgelegt ist, dass das Ausschneiden der Karte einen Teil der Kontaktstreifen (10) an der Randfläche der Karte frei belässt.

10. Verfahren nach Anspruch 9, wobei der Stapel ferner vor dem Laminieren eine Schutz-Polymerschicht (45) für eine zweite Schicht aus Polymermaterial (46) zum Bilden einer zweiten Fläche der Karte an den ersten Polymerschichten (41, 42) zur Verkapselung der Komponenten umfasst.

11. Verfahren nach Anspruch 9, wobei die Karte zwei flexible Schaltungen umfasst, wobei das Verfahren vor dem Laminieren ferner umfasst:
a. das Anbringen an den ersten Schichten (41, 42) zur Verkapselung von Komponenten von zweiten Schichten (42', 41') zur Verkapselung von Komponenten einer zweiten flexiblen Schaltung;
b. das Anbringen der ersten Fläche der zweiten flexiblen Schaltung (20') an den zweiten Schichten;
c. das Anbringen an der zweiten Fläche der zweiten flexiblen Schaltung einer zweiten Schicht aus Polymermaterial (51') zum Bilden einer zweiten Fläche der Karte.

12. Verfahren nach einem der Ansprüche 9, 10 oder 11, wobei das Ausschneiden der Karte plan mit dem Ende der Streifen erfolgt.

13. Verfahren nach einem der Ansprüche 9, 10 oder 11, wobei das Ausschneiden der Karte einen Teil des Sturzes der Streifen abschert.

14. Verfahren nach einem der Ansprüche 9 bis 13, wobei das Ausschneiden der Karte mittels einer Stanz/Matrix-Vorrichtung durchgeführt wird.

15. Verfahren nach einem der Ansprüche 9 bis 14, umfassend einen oder mehrere Schritte eines Anbringens eines Haftmittels zwischen einer oder mehreren Flächen der flexiblen Schaltung und einer oder mehreren Polymerschichten.

## Claims

1. An electronic card produced in a format such as a credit card format and, in particular, in a flexible chip card format (1), is provided with at least one flexible circuit (20) comprising a first face accommodating electronic components (3) and a second face that is provided with contact tabs (10) that are intended to be connected to conductive tracks of a clothing textile, said flexible circuit being covered, on its first face, with first polymer layers for encapsulating the components (41, 42, 43, 44) and covered, on its second face, with at least one first layer (51) of polymer material for producing an outer face of the card which is provided with cutouts for accessing the contact tabs (10), **characterized in that** at least some of the contact tabs are produced at the edge of the card and provided with a terminal portion (12) on the edge face of the card.

2. The electronic card as claimed in claim 1, wherein the second face of the flexible circuit comprises, at a distance from the edges of the card, contact pads (2) for connecting to a chip card reader.

3. The electronic card as claimed in claim 1 or 2, wherein, with the card being a laminated card, said contact tabs (10) are flush with the surface of the card after lamination.

4. The electronic card as claimed in claim 1, 2 or 3, wherein the terminal portions of the contact tabs (12a) on the edge face (25) of the card are level with the plane of the edge face of the card and comprise a sharp or rounded edge.

5. The electronic card as claimed in claim 1, 2 or 3, wherein the end portions of the contact tabs on the edge face of the card are portions (12b) of the tabs that are rounded or curved, or portions (12c) that are cantilevered over the edge face (25) of the card.

6. The electronic card as claimed in any one of the preceding claims, wherein the first polymer layers for encapsulating the components are covered by at least one layer of protective polymer material and one second layer of polymer material (51) for producing an outer face of the card.

7. The electronic card as claimed in any one of claims 1 to 5, comprising two flexible circuits (20, 20') that are provided with contact tabs that are produced at the edge of the card, each flexible circuit being arranged under an outer face of the card, said flexible circuits being separated by polymer layers for encapsulating the components (41, 42, 41', 42').

8. The electronic card as claimed in any one of the preceding claims, wherein one or more layers of adhesive are interposed between the flexible circuit and the polymer layers.

9. A method for manufacturing electronic cards in a flexible chip card format, comprising:
a. producing at least one flexible circuit blank (20) that is provided with lateral handling perforations (21) on two opposite edges, with connection tracks (4, 5) on a first face and on a second face of said blank, and is further provided, on its second face, with contact tabs (10) that are aligned along at least one of said edges and close to said edge;
b. depositing electronic components (3a, 3b) that are connected to at least some of the connection tracks (4) of a first face of the flexible circuit by soldering, brazing, flip chip, SMD or wire bonding on said first face of said flexible circuit blank;
**characterized in that** it further comprises:
c. producing a stack of layers around the flexible circuit blank such that the stack comprises at least first polymer layers for encapsulating the components (41, 42) on the first face of the flexible circuit blank and comprises at least one second polymer layer (51) for producing an outer face of the card on the second face of the flexible circuit blank (20), said at least one second polymer layer being provided with cutouts for accessing said contact tabs (10);
d. hot or cold rolling the assembly of sheets and said at least one flexible circuit blank,
e. cutting out the card from the assembly of laminated layers such as the position where the card is cut out with respect to said edge is fixed so that cutting out the card leaves some of said tabs (10) exposed on the edge face of the card.

10. The method as claimed in claim 9, wherein the stack further comprises, before lamination, a protective polymer layer (45), a second layer of polymer material (46) for forming a second face of the card on the first polymer layers (41, 42) for encapsulating the components.

11. The method as claimed in claim 9, wherein, with the card comprising two flexible circuits, the method further comprises, before lamination:
a. depositing, on the first layers (41, 42) for encapsulating the components, second layers (42', 41') for encapsulating components of a second flexible circuit;
b. depositing the first face of the second flexible circuit (20') on said second layers;
c. depositing, on the second face of the second flexible circuit, a second layer of polymer material (51') for forming a second face of the card.

12. The method as claimed in any one of claims 9, 10 or 11, wherein the card is cut out flush with the end of the tabs.

13. The method as claimed in any one of claims 9, 10 or 11, wherein cutting out the card shears off a portion of the tabs.

14. The method as claimed in any one of claims 9 to 13, wherein the card is cut out by means of a punch/die device.

15. The method as claimed in any one of claims 9 to 14, comprising one or more steps of applying adhesive between one or more faces of the flexible circuit and one or more polymer layers.
